# EUROPEAN PATENT APPLICATION

(11) **EP 1 814 025 A1**
(43) Date of publication of application: **01.08.2007**
(21) Application number: 06100510.4
(22) Date of filing: 18.01.2006
(51) Int. Cl.: G06F 7/58, G06F 9/45

(54) **Random code generation**

(30) Priority: 18.01.2006 US 61501
(71) Applicant: MICROSOFT CORPORATION, Redmond, Washington 98052-6399 (US)
(72) Inventor: Wadsworth, Brandon Scott, 98052, Redmond (US)
(74) Representative: Zimmer, Franz-Josef

(57) **Abstract**

Random code generation may include utilizing a statistical breakdown of real world code to randomly generate code that is lexically and structurally valid.

## Description

The invention relates to code generation methods, computer-readable media, and testers.

### SUMMARY

The invention is claimed by the independent claims. Preferred embodiments are specified by the dependent claims.

### DRAWINGS

The detailed description refers to the following drawings.

FIG. 1 shows a network environment in which examples of random code generation may be implemented.

FIG. 2 shows a processing flow for an example implementation of random code generation.

FIG. 3 shows an example statistical table in accordance with an example implementation of random code generation.

FIG. 4 shows an example of a system that is capable of implementing random code generation.

### DETAILED DESCRIPTION

Random code generation based on real world code is described herein.

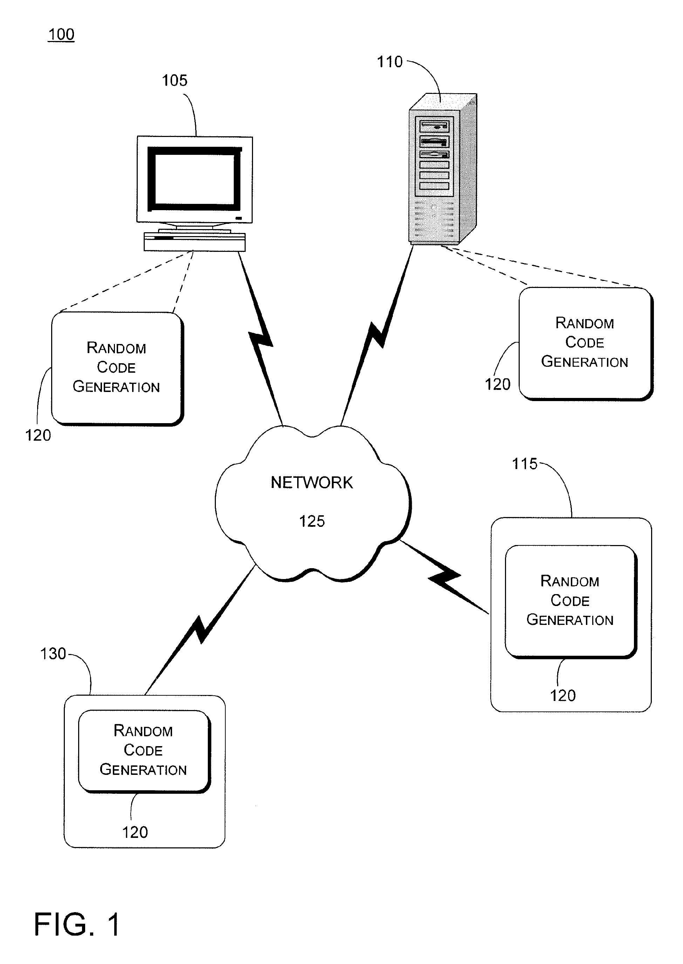

FIG. 1 shows an example network environment in which random code generation may be implemented. More particularly, any one of client device 105, server device 110, "other" device 115, and data source 130 may be capable of random code generation 120, as described herein. Further, devices 105, 110, 115, and 130 may be communicatively coupled to one another through network 125. Therefore, random code generation 120 may be implemented by any of devices 105, 110, 115, and 130 based upon methods that were previously generated locally or that were generated at any other of devices 105, 110, 115, and 130.

Client device 105 may be at least one of a variety of conventional computing devices, including, but not limited to, a desktop personal computer (PC), workstation, mainframe computer, Internet appliance, set-top box, and media device. Further, client device 105 may be at least one of any device that is capable of being associated with network 125 by a wired and/or wireless link, including, but not limited to, a personal digital assistant (PDA), laptop computer, cellular telephone, etc. Further still, client device 105 may represent the client devices described above in various quantities and/or combinations thereof. "Other" device 115 may also be embodied by any of the above examples of client device 105.

Server device 110 may provide any of a variety of data and/or functionality to client device 105 or "other" device 115. The data may be publicly available or alternatively restricted, *e.g*., restricted to only certain users or only if an appropriate subscription or licensing fee is paid. Server device 110 may be at least one of a network server, an application server, a web blade server, or any combination thereof. Typically, server device 110 is any device that is the source of content, and client device 105 is any device that receives such content either via network 125 or via an off-line medium. However, according to the example implementations described herein, server device 105 and client device 110 may interchangeably be a sending host or a receiving host. "Other" device 115 may also be embodied by any of the above examples of server device 110.

"Other" device 115 may further be any device that is capable of random code generation 120 according to one or more of the examples described herein. That is, "other" device 115 may be any software-enabled computing or processing device that is capable of randomly generating a method, or portion thereof, based on a sampling of at least one other known application, program, function, or other assemblage of programmable and executable code, in either of a managed execution environment or a testing environment. Thus, "other" device 115 may be a computing or processing device having at least one of an operating system, an interpreter, converter, compiler, or managed execution environment implemented thereon. These examples are not intended to be limiting in any way, and therefore should not be construed in such manner.

Network 125 may represent any of a variety of conventional network topologies, which may include any wired and/or wireless network. Network 125 may further utilize any of a variety of conventional network protocols, including public and/or proprietary protocols. For example, network 125 may include the Internet, an intranet, or at least portions of one or more local area networks (LANs).

Data source 130 may represent any one of a variety of conventional computing devices, including a desktop personal computer (PC), that may be capable of random code generation 120 in connection with an application, program, function, or other assemblage of programmable and executable code, which may or may not be written in object-oriented code. Alternatively, data source 130 may also be any one of a workstation, mainframe computer, Internet appliance, set-top box, media device, personal digital assistant (PDA), laptop computer, cellular telephone, *etc.,* that may be capable of transmitting at least a portion of an application, program, or function to another work station. Further, although data source 130 may be a source of code for the application, program, or function upon which random code generation 120 may be predicated, data source 130 may be regarded as at least the source of a method, or portion thereof, that results from an implementation of random code generation 120. Regardless of the implementation, known methods, applications, programs, or functions that may serve as a basis for random code generation 120 may be transmitted from data source 130 to any of devices 105, 110, and 115 as part of an on-line notification via network 125 or as part of an off-line notification.

Random code generation 120 may include leveraging a statistical breakdown of real world (*i.e.,* known) code to randomly generate code (hereafter referred to as "code") that is lexically valid and also has real world structural characteristics. Thus, in a testing environment for instance, a processing component may be tested by receiving and/or executing randomly generated code that has characteristics of actual customer applications (*i.e.*, real world code) to thereby provide the component with a realistic test scenario. In turn, the component produces a realistic test result. Further, in addition to a testing environment, random code generation 120 may have further relevance when implemented in an unmanaged execution environment or a managed execution environment.

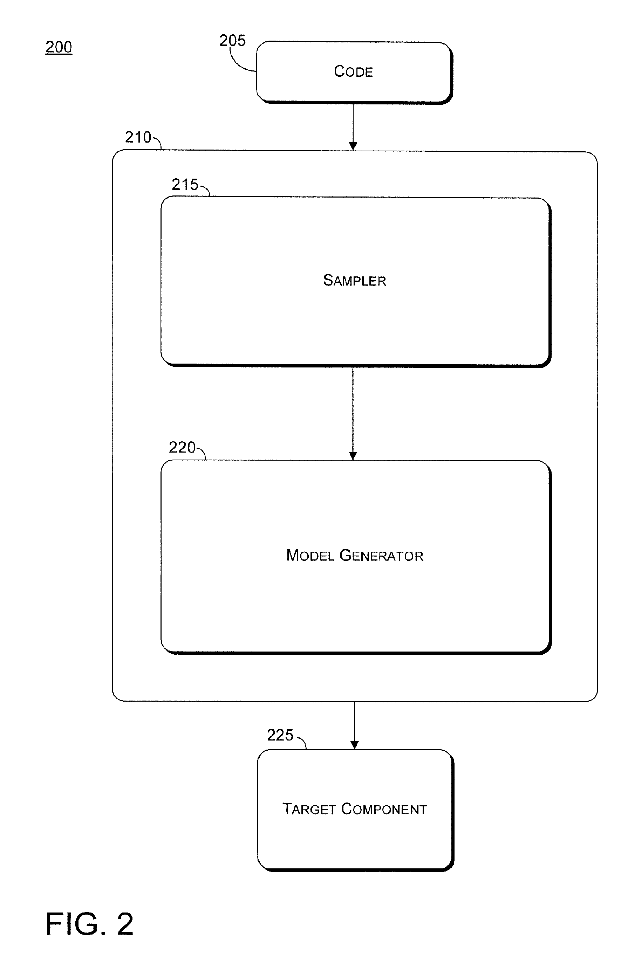

FIG. 2 shows processing flow 200 as an example implementation of random code generation 120 (see FIG. 1) in accordance with real world code characteristics and properties.

Code 205 may refer to, at least, methods, applications, programs, functions, or other assemblages of programmable and executable code. According to at least one example, code 205 may be "real world code" (*i.e.,* code that is known) including intermediate language (hereafter "IL") or assembly language. Both IL and assembly language may be used as an intermediary between a high-level source code and a target (*i.e.,* machine-readable) code.

However, code 205 is not limited to the examples of IL and assembly language. Rather, for implementation of random code generation 120, code 205 may be written in any one of a variety of known languages for which at least one of multiple characteristics may be sampled statistically. Such characteristics may include the lexicon and construct properties that are particular to a language for code 205. Non-limiting examples of such lexical characteristics and construct properties may include: method structure, method flow control structures, method data flow, instruction frequencies, object type usage, unsafe code usage, generic type usage, loop usage, exception handling, or frame usage.

Constructor 210 may be regarded as a component or module in which at least portions of random code generation 120 may be implemented. Various operations associated with constructor 210 may be performed by sampler 215 and model generator 220, either singularly or in concert together. Alternatively, operations associated with constructor 210 may be carried out by the component or module itself, or by the component or module in cooperation with the network node in which the module is included or associated (*i.e.,* by a processor or processors in which constructor 210 is included or associated). In other implementations, the operations of constructor 210, including those of sampler 215 and model generator 220, may be implemented as hardware, firmware, or some combination of hardware, firmware, and software, either singularly or in combination therewith.

Further still, the components or modules of constructor 210 may be provided as separate components or modules, as depicted in FIG. 2, in a common environment. However, at least one alternative embodiment of constructor 210 may dispose the corresponding components or modules in separate processing environments. Even further, the components or modules of constructor 210 may be provided as a single component or module.

Sampler 215 may receive code 205 from, *e.g.,* server device 110 or data source 130 (see FIG. 1). As set forth above, code 205 may be provided in, *e.g.,* IL or assembly language code. Typically, then, sampler 215 may be able to produce a statistical breakdown of code 205 with regard to, at least, the aforementioned lexical characteristics and construct properties of the language in which code 205 is written. More particularly, for any application, program, function, or other assemblage of programmable and executable code received as code 205, sampler 215 may be able to produce a statistical table indicative of the, *e.g.,* variables, instructions, structures, usages, rules, *etc.,* (including, but not limited to, number of occurrences, percentages, *etc.*), with regard to code 205. Further, the statistical table for code 205 produced by sampler 215 may be a statistical model for an individual application, program, function, or other assemblage of programmable and executable code received as code 205, or an aggregate statistical model for multiple methods, applications, programs, functions, or other assemblages of programmable and executable code received as code 205.

Model generator 220 may utilize the aforementioned statistical table received from sampler 215 in order to generate at least one new application, program, function, or other assemblage of programmable and executable code. Model generator 220 may have knowledge of lexical characteristics and structural properties that are particular to a language for code 205. Accordingly, model generator 220 may be able to utilize the statistical table produced by sampler 215 to direct a method for randomly generating code. More particularly, multiple permutations of code may be randomly generated by arranging lexicon that is particular to the language for code 205 in accordance with structural properties thereof, all predicated upon one or more models of the statistical table received from sampler 215.

Target component 225 may be a component or module that is to receive code that has been randomly generated by constructor 210, particularly model generator 220. Target component 225 may benefit from receiving code randomly generated by model generator 220 in a testing environment. That is, model generator 220 may randomly generate code in the order of millions or even billions depending upon the volume of methods, applications, programs, functions, or other assemblages of programmable and executable code received as code 205 into constructor 210. Thus, target component 225 may be exposed to a high magnitude of test code that resembles real-world code in terms of, at least, lexicon and structure.

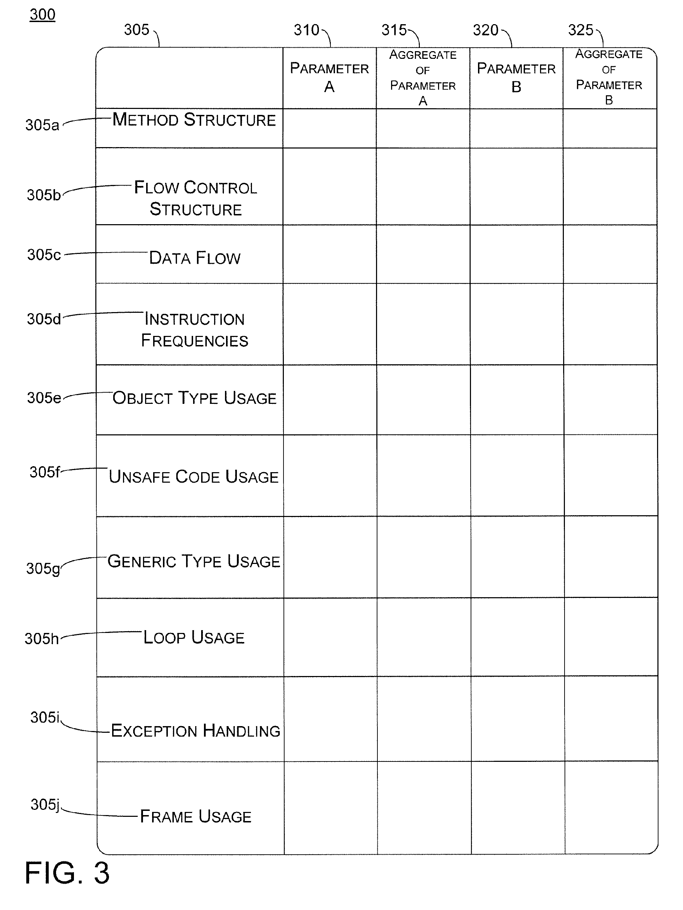

FIG. 3 shows example statistical table 300 in accordance with an example implementation of random code generation 120 (see FIG. 1) in accordance with real world code characteristics and properties. More particularly, statistical table 300 may represent the statistical breakdown of one or more lexical characteristics and structural properties of code 205 as received at constructor 210.

Column 305 of statistical table 300 shows a non-limiting set of example lexical characteristics and structural properties, including: method structure 305a, method flow control structure 305b, method data flow 305c, instruction frequencies 305d, object type usage 305e, unsafe code usage 305f, generic type usage 305g, loop usage 305h, exception handling 305i, and frame usage 305j.

Columns 310, 315, 320, and 325 may represent example samplings of the aforementioned lexical and structural characteristics shown in column 305. For instance, column 310 may represent a statistical breakdown of Parameter A, which may a specified lexical characteristic or structural property for a single entity received as code 205; and column 315 may be an aggregate of Parameter A for multiple methods, applications, programs, functions, or other assemblages of programmable and executable code received as code 205. Similarly, column 320 may represent a statistical breakdown of Parameter B, which may be another lexical characteristic or structural property for a single entity received as code 205; and column 325 may be an aggregate of Parameter B for multiple methods, applications, programs, functions, or other assemblages of programmable and executable code received as code 205. Of course, table 300 may have numerous variations in terms of structure and content. Thus, table 300 of FIG. 3 is merely presented as an example of a statistical breakdown for code 205.

The following is a non-exclusive listing and description of example lexical characteristics and construct properties that may be sampled in table 300, in terms of, at least, count and frequency.

Method structure 305a: with respect to code 205, a statistical breakdown of method structure 305a may include : size of methods; stack depth; return type; arguments (e.g., simple types, object types, garbage collection types (in a managed execution environment), arrays, and value types); instance types; static types; use of external methods; use of external fields; use of special call types (e.g., variable argument length calls) or platform invoke type calls.

Internal method control flow structure 305b: with respect to code 205, a statistical breakdown of internal method control flow structure 305b may include: use of branches; ratio of forward/reverse branches; use of conditional branches; creation of loops; and use of exception handling flow control (in a managed execution environment).

Internal method data flow 305c, which relates to aspects of type flow in code 205: with respect to code 205, a statistical breakdown of internal method data flow may include: traditional compiler data flow analysis such as statistics regarding single use, multiple use variables; single-assign, multiple assign variables; flow of input parameters into local variables; flow of a sub-method returning data into local variables; flow of values into local variables into parameters for calls to sub-methods; flow of values from local variables to flow control decisions; flow of values from local variables into returned types; addresses of variables taken; flow into static and instance variables; flow out of static and instance variables; and a number and location of stack empty points.

Instruction frequencies 305d: with respect to code 205, a statistical breakdown of instruction frequencies 305d may include: a numerical sampling of the use of particular instructions; a sampling of the use of particular instructions in concert with other instructions; a sampling of a balance of verifiable and non-verifiable instructions; and a sampling of the types of address composition.

Object type usage 305e: with respect to code 205, a statistical breakdown of object type usage 305e may include: a source of used objects; and types of objects used including, but not limited to: assignment, box/unbox, call-on, perform virtual calls on, and generic types.

Use of unsafe code 305f: with respect to code 205, a statistical breakdown of the use of unsafe code 305f may include: details about the unsafe code in code 205, and details about address resolution thereof.

Use of generic types 305g in code 205.

Details of loops: with respect to code 205, a statistical breakdown of the details of loops may include: loop control variables; dead loops; exception handling in a loop (in a managed execution environment); a thrower in a loop; calls in a loop; and array access from inside a loop.

Exception handling (in a managed execution environment) 305h: with regard to code 205, a statistical breakdown of exception handling 305h may include a description of: a filter; the size of try; the size of catch; the size of finally; a percentage of a method size; calls in each inquiry; and flow of data from local variables/stack into exception handling.

Use of frames 305i: with regard to code 205, a statistical breakdown of the use of frames may include: a description of boxing; a description of loops; a description of array checks; a description of simple instance member accessor; a description of casting; a description of a copy object; a description of a local locator; a description of a switch; and a description of a decompose array and call.

The lexical characteristics and structural properties listed and described above are provided as examples only. Alternative examples of table 300 may include various combinations of the above characteristics as well as others deemed to be of interest to one implementing random code generation 120.

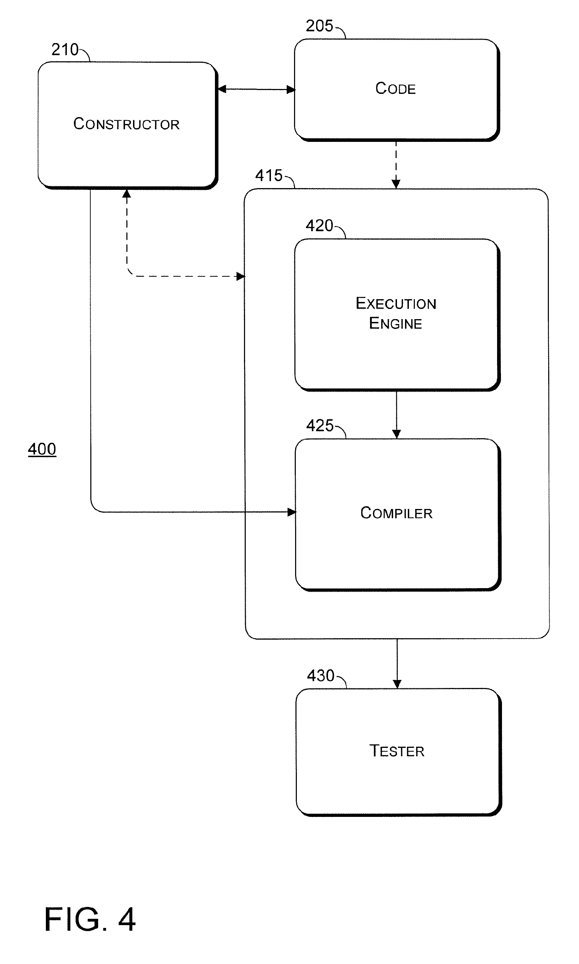

FIG. 4 shows example system 400 in which random code generation 120 (see FIG. 1) may be implemented. More particularly, system 400 illustrates how random code generation 120 may be implemented in managed execution environment 415. System 400 is described below by referencing elements of both FIG. 2 and FIG. 3. However, such construction and configuration of system 400 is provided only as an example, and should not be inferred as being limiting in any manner.

Managed execution environment 415 may provide one or more routines for an application program to perform properly in an operating system because a method, application, program, function, or other assemblage of programmable and executable code may require another software system in order to execute. Thus, such code may call one or more managed execution environment routines, which may reside between the application program and the operating system, and the managed execution environment routines may call the appropriate operating system routines.

Managed execution environments have been developed to enhance the reliability of software execution on a growing range of processing devices including servers, desktop computers, laptop computers, and a host of mobile processing devices. Managed execution environments may provide a layer of abstraction and services to an application running on a processing device (e.g., devices 105, 110, 115, and 130 described above in reference to FIG. 1). Managed execution environments may further provide such an application with capabilities including error handling and automatic memory management. Examples of managed execution environments may include: Visual Basic runtime execution environment; Java^{®} Virtual Machine runtime execution environment that is used to run, *e.g.,* Java^{®} routines; or Common Language Runtime (CLR) to compile, *e.g.,* Microsoft NET^{™} applications into machine language before executing a calling routine.

Code 205, as described above with reference to FIG. 2, may refer to one or more of, at least, methods, applications, programs, functions, or other assemblages of programmable and executable code written in *e.g.,* IL or assembly language.

Constructor 210, as described above with reference to FIG. 2, may refer to one or more components for implementing at least portions of random code generation 120. According to at least one example implementation in an unmanaged execution environment, constructor 210 may call into a data source to receive code 205 in an unmanaged execution environment. Alternatively, at least one example in a managed execution environment may include constructor 210 calling into execution engine 420 to receive code 205.

Execution engine 420, at least in a managed execution environment, may refer to a portion of code 205 that indicates how code 205 is to be managed and manipulated.

Regardless of how constructor 210 receives code 205, constructor 210 may implement example process 200 (see FIG. 2) by which statistical table 300 (see FIG. 3) is produced. That is, constructor 210 may produce a statistical model for one or more methods, applications, programs, functions, or other assemblages of programmable and executable code received as code 205. The statistical model may include, at least, a breakdown of the lexical characteristics and construct properties of code 205.

Constructor 210 may further utilize statistical table 300 based on the lexical characteristics and construct properties of code 205 to randomly generate multiple permutations of code by arranging the lexicon in accordance with construct properties that are particular to the code 205, predicated upon one or more models of statistical table 300.

According to at least one example of a testing environment, constructor 210 may then submit the code randomly generated by constructor 210 to compiler 41 5 in managed execution environment 415. Thus, by being subjected to myriad of possible code combinations randomly generated by constructor 210, the ability of compiler 415 to process different combinations of code as well as to expose programming bugs may be tested.

Compiler 425 may be regarded as just one example of a target object for the scores of permutations of code 205 that may be generated by constructor 210. However, purposeful, random generation of code may be likely, though not exclusively, be intended for testing purposes. Thus, according to at least one alternative example of FIG. 4, the target of the randomly generated code may be any component or module within managed execution environment 415 for which purposeful testing may be accomplished by receiving scores (in the order of, at least, millions) of randomly generated code that read and are constructed in a same manner as real-world code.

Tester 430 may refer to a component or module, either in an unmanaged execution environment or within managed execution environment 415, that collects the testing data of compiler 425 or an alternative target object of the randomly generated code.

Accordingly, testing in both unmanaged and managed execution environments may be made more purposeful and effective by the random generation of code that is constructed like real-world methods, applications, programs, functions, or other assemblages of programmable and executable code, in terms of lexicon or grammar and construct characteristics.

The examples described above, with regard to FIGS. 1-4, may be implemented in a computing environment having components that include, but are not limited to, one or more processors, system memory, and a system bus that couples various system components. Further, the computing environment may include a variety of computer readable media that are accessible by any of the various components, and includes both volatile and non-volatile media, removable and non-removable media.

Various modules and techniques may be described herein in the general context of computer-executable instructions, such as program modules, executed by one or more computers or other devices. Generally, program modules include routines, programs, objects, components, data structures, etc. for performing particular tasks or implement particular abstract data types. Typically, the functionality of the program modules may be combined or distributed as desired in various embodiments.

An implementation of these modules and techniques may be stored on or transmitted across some form of computer readable media. Computer readable media can be any available media that can be accessed by a computer. By way of example, and not limitation, computer readable media may comprise "computer storage media" and "communications media."

"Computer storage media" includes volatile and non-volatile, removable and non-removable media implemented in any method or technology for storage of information such as computer readable instructions, data structures, program modules, or other data. Computer storage media includes, but is not limited to, RAM, ROM, EEPROM, flash memory or other memory technology, CD-ROM, digital versatile disks (DVD) or other optical storage, magnetic cassettes, magnetic tape, magnetic disk storage or other magnetic storage devices, or any other medium which can be used to store the desired information and which can be accessed by a computer.

"Communication media" typically embodies computer readable instructions, data structures, program modules, or other data in a modulated data signal, such as carrier wave or other transport mechanism. Communication media also includes any information delivery media. The term "modulated data signal" means a signal that has one or more of its characteristics set or changed in such a manner as to encode information in the signal. As a non-limiting example only, communication media includes wired media such as a wired network or direct-wired connection, and wireless media such as acoustic, RF, infrared, and other wireless media. Combinations of any of the above are also included within the scope of computer readable media.

Reference has been made throughout this specification to "one embodiment," "an embodiment," or "an example embodiment" meaning that a particular described feature, structure, or characteristic is included in at least one embodiment of the present invention. Thus, usage of such phrases may refer to more than just one embodiment. Furthermore, the described features, structures, or characteristics may be combined in any suitable manner in one or more embodiments.

One skilled in the relevant art may recognize, however, that the invention may be practiced without one or more of the specific details, or with other methods, resources, materials, etc. In other instances, well known structures, resources, or operations have not been shown or described in detail merely to avoid obscuring aspects of the invention.

While example embodiments and applications of the present invention have been illustrated and described, it is to be understood that the invention is not limited to the precise configuration and resources described above. Various modifications, changes, and variations apparent to those skilled in the art may be made in the arrangement, operation, and details of the methods and systems of the present invention disclosed herein without departing from the scope of the claimed invention.

## Claims

1. A method, comprising:
constructing a statistical table based on a sampled method; and
generating a new method based on a construct of the statistical table.

2. A method according to Claim 1, wherein the constructing is performed in a managed execution environment.

3. A method according to Claim 1, wherein the sampled method derives from an unmanaged execution environment.

4. A method according to Claim 1, wherein the wherein the statistical table includes an aggregation of one or more specified parameters from the known method.

5. A method according to Claim 1, wherein the statistical table includes an aggregation of data from the known method includes data pertaining to at least one of method structure, method flow control structures, method data flow, instruction frequencies, object type usage, unsafe code usage, generic type usage, loop usage, exception handling, or frame usage.

6. A method according to Claim 1, wherein the generating includes assembling intermediate language code according to the construct of the statistical table.

7. A method according to Claim 1, further comprising transmitting the new method to a compiler.

8. A computer-readable medium having one or more executable instructions that, when read, cause one or more processors to:
sample a known method into an intermediate language;
create a statistical breakdown of the sampled method; and
generate a new method in the intermediate language based on the statistical breakdown of the sampled method.

9. A computer-readable medium according to Claim 8, comprising one or more executable instructions that cause the one or more processors to further:
compile the new method.

10. A computer-readable medium according to Claim 8, wherein the one or more executable instructions to create the statistical breakdown of the sampled method further cause the one or more processors to combine the statistical breakdown with a statistical breakdown created for another sampled method, and wherein further the one or more executable instructions to generate the new method cause the one or more processors to generate the new method based on the combined statistical breakdown.

11. A computer-readable medium according to Claim 8, wherein the statistical breakdown of the sampled method includes data pertaining to at least one of method structure, method flow control structures, method data flow, instruction frequencies, object type usage, unsafe code usage, generic type usage, loop usage, exception handling, or frame usage.

12. A computer-readable medium according to Claim 8, wherein the one or more processors process the one or more instructions in a managed execution environment.

13. A computer-readable medium according to Claim 8, wherein the one or more processors process the one or more instructions in an unmanaged execution environment.

14. A tester, comprising:
a sampler to build a statistical model for methods sampled thereby; and
a generator to generate new methods based on the statistical model.

15. A tester according to Claim 14, further comprising a compiler to translate the new methods into machine language.

16. A tester according to Claim 14, wherein the sampler is to build a statistical model for the methods based on at least one of method structure, method flow control structures, method data flow, instruction frequencies, object type usage, unsafe code usage, generic type usage, loop usage, exception handling, or frame usage.

17. A tester according to Claim 14, wherein the sampler is to receive the methods from a source in an unmanaged execution environment.

18. A tester according to Claim 14, wherein the sampler is receive the methods from an execution engine in a managed execution environment.
